# EUROPEAN PATENT APPLICATION

(11) **EP 4 379 815 A1**
(43) Date of publication of application: **05.06.2024**
(21) Application number: 23855830.8
(22) Date of filing: 30.08.2023
(51) Int. Cl.: H01L 31/0216, H01L 31/04, H01L 31/18

(54) **SOLAR CELL AND MANUFACTURING METHOD THEREFOR**

(30) Priority: 29.09.2022 CN 202211201633
(71) Applicant: Tongwei Solar (Meishan) Co., Ltd., Meishan, Sichuan 620041 (CN)
(72) Inventor: DENG, Mingzhang, Meishan, Sichuan 620041 (CN); XING, Guoqiang, Meishan, Sichuan 620041 (CN)
(74) Representative: Marks & Clerk LLP
(86) International application number: PCT/CN2023/115806
(87) International publication number: WO 2024/066884

(57) **Abstract**

The present application provides a solar cell including a crystalline silicon substrate. A doped silicon oxide layer (131), a doped polycrystalline silicon film (132), and a back aluminum oxide film (133) are sequentially disposed on a back side of the crystalline silicon substrate. The doped polycrystalline silicon film (133) has a thickness of 5 nm to 50 nm. A back metal electrode (150) is also provided on the back side of the crystalline silicon substrate. The back metal electrode (150) passes through the back aluminum oxide film (133) to be in contact with the doped polycrystalline silicon film (132).

## Description

This application claims priority to Chinese Patent Application No. 202211201633X entitled "SOLAR CELL AND PREPARATION METHOD THEREOF" filed with the Chinese Patent Office on September 29, 2022, which is hereby incorporated by reference in its entirety.

### TECHNICAL FIELD

The present application relates to the field of photovoltaics, and in particular to a solar cell and a preparation method thereof.

### BACKGROUND

In recent years, the passivation contact technology has been gradually and widely applied in crystalline silicon solar cells, which mainly involves using an ultra-thin tunneling oxide layer and a doped polycrystalline silicon (poly-Si) film as a passivation layer and a metal contact layer on a back side of a solar cell, and forming Ohmic contact between a metal electrode and a heavily-doped poly-Si film, to reduce the metal recombination and improve the cell performance. The N-type tunnel oxide passivated contact (TOPCon) cell, which was developed by Dr. Frank Feldmann of Fraunhofer ISE, Germany in 2013, is a type of solar cell based on a tunneling oxide layer passivation contact technology of a selective carrier principle. In the structure of the TOPcon solar cell, the difference between the quasi Fermi levels of electrons of highly doped polycrystalline silicon (poly Si) and crystalline silicon causes the downward bending of the energy band at n-Si interface and a low potential energy barrier of electrons at the interface, which facilitates the accumulation of electrons at interface and blocks holes from arriving at the SiO₂/Si interface, thereby achieving the selective collection of electrons and effectively reducing the recombination of electron-hole pairs at the back side. In addition, the highly-doped poly-Si also has an impurity absorption effect, thereby significantly improving the passivation effect and thus increasing the open-circuit voltage of the solar cell.

In large-scale industrial production of the tunnel oxide passivated contact (TOPCon) solar cell, the metallization is mainly achieved by screen printing a metal paste followed by high-temperature sintering. However, in the process of high-temperature sintering, a part of the metal paste may pass to the crystalline silicon substrate through the doped poly-Si film, exerting a negative influence on the tunneling passivation effect. At present, the main way to widen the sintering window of the metal paste is to increase the thickness of the doped poly-Si film, and the polycrystalline silicon film in the TOPcon solar cell which have been mass-produced in industry has a thickness of 100 nm to 200 nm. However, the thickened doped poly-Si film has the problem of parasitic absorption of the near infrared spectrum. The absorption of the near infrared spectrum by the doped polycrystalline silicon will not cause the excitation of the electron-hole pairs, causing a reduced utilization rate of sunlight by the solar cell. The larger the thickness of the doped poly-Si film, the larger the loss of the parasitic absorption current, the lower the utilization rate of long waves by the solar cell, and finally the lower the short-circuit current of the TOPCon cell. Therefore, increasing the thickness of the doped poly-Si film protects the passivation effect of the tunneling oxide layer and the polycrystalline silicon, but sacrifices some short-circuit current of the solar cell, resulting in the loss of the short-circuit current.

### SUMMARY

According to some embodiments of the present application, a solar cell is provided. The solar cell includes a crystalline silicon substrate. A doped silicon oxide layer, a doped polycrystalline silicon film, and a back aluminum oxide film are sequentially disposed on a back side of the crystalline silicon substrate. A back metal electrode is also disposed on the back side of the crystalline silicon substrate. The back metal electrode passes through the back aluminum oxide film to form contact with the doped polycrystalline silicon film.

In some embodiments of the present application, the doped polycrystalline silicon film has a thickness of 5 nm to 50 nm.

In some embodiments of the present application, the solar cell further includes a back silicon nitride film disposed on the back aluminum oxide film away from the crystalline silicon substrate.

In some embodiments of the present application, the back silicon nitride film has a thickness of 70 nm to 100 nm.

In some embodiments of the present application, the solar cell further includes a front aluminum oxide film disposed on a front side of the crystalline silicon substrate.

In some embodiments of the present application, the front aluminum oxide film has a thickness of 3 nm to 8 nm.

In some embodiments of the present application, the solar cell further includes a front silicon nitride film disposed on a side of the front aluminum oxide film away from the crystalline silicon substrate.

In some embodiments of the present application, the front silicon nitride film has a thickness of 70 nm to 100 nm.

In some embodiments of the present application, the solar cell further includes a front metal electrode passing through the front silicon nitride film and the front aluminum oxide film to form contact with the crystalline silicon substrate.

In some embodiments of the present application, the crystalline silicon substrate includes an N-type silicon wafer and a boron-diffused layer. A front side of the N-type silicon wafer has a textured surface, and a back side of the N-type silicon wafer has a polished surface. The boron-diffused layer is disposed on the textured surface. The front aluminum oxide film is disposed on the boron-diffused layer. The front metal electrode is in contact with the boron-diffused layer. The doped silicon oxide layer is disposed on the polished surface.

In some embodiments of the present application, the doped silicon oxide layer has a thickness of 1 nm to 2 nm.

In some embodiments of the present application, the back aluminum oxide film has a thickness of 1 nm to 8 nm.

A preparation method of a solar cell is provided. The preparation method includes the following steps:
sequentially forming a doped silicon oxide layer, a doped polycrystalline silicon film, and a back aluminum oxide film on a back side of a crystalline silicon substrate, wherein the doped polycrystalline silicon film has a thickness of 5 nm to 50 nm; and
forming a back metal electrode on the back side of the crystalline silicon substrate, wherein the back metal electrode passes through the back aluminum oxide film to form contact with the doped polycrystalline silicon film.

In some embodiments of the present application, the preparation method further includes the following step: forming a back silicon nitride film on the back aluminum oxide film.

In some embodiments of the present application, the back silicon nitride film has a thickness of 70 nm to 100 nm.

In some embodiments of the present application, the preparation method further includes the following step: forming a front silicon nitride film on a front side of the crystalline silicon substrate, wherein the front silicon nitride film and the back silicon nitride film are simultaneously deposited by the same preparation manner which is plasma-enhanced chemical vapor deposition.

In some embodiments of the present application, the front silicon nitride film has a thickness of 70 nm to 100 nm.

In some embodiments of the present application, the preparation method further includes the following step: forming a front aluminum oxide film on the front side of the crystalline silicon substrate, wherein the front aluminum oxide film and the back aluminum oxide film are simultaneously deposited in the same preparation manner or separately deposited by different preparation methods selecting from atomic layer deposition, plasma-enhanced chemical vapor deposition, or plasma-enhanced atomic layer deposition.

In some embodiments of the present application, the front aluminum oxide film has a thickness of 3 nm to 8 nm.

In some embodiments of the present application, the doped polycrystalline silicon film is prepared by low pressure chemical vapor deposition or plasma-enhanced chemical vapor deposition.

In some embodiments of the present application, the preparation method for the crystalline silicon substrate further includes the following steps:
texturing an N-type silicon wafer to form a textured surface on a front side of the N-type silicon wafer;
performing boron diffusion on surfaces of the textured N-type silicon wafer to form a boron-diffused layer; and
removing the boron-diffused layer on a back surface and a lateral surface of the N-type silicon wafer by alkali polishing to form a polished surface on a back side of the N-type silicon wafer.

In some embodiments of the present application, the boron-diffused layer is formed on the surfaces of the textured N-type silicon wafer by BCl₃ at 900°C to 1050°C.

In some embodiments of the present application, the doped silicon oxide layer has a thickness of 1 nm to 2 nm.

In some embodiments of the present application, the back aluminum oxide film has a thickness of 1 nm to 8 nm.

### BRIEF DESCRIPTION OF THE DRAWINGS

To describe the technical solutions in the embodiments of the present application more clearly, the following briefly introduces the accompanying drawings required for describing the embodiments of the present application. It should be understood that the following drawings only illustrate some embodiments of the present application, and therefore should not be construed as limiting the scope. For a person of ordinary skill in the art, other related drawings can also be obtained according to these drawings without creative efforts.

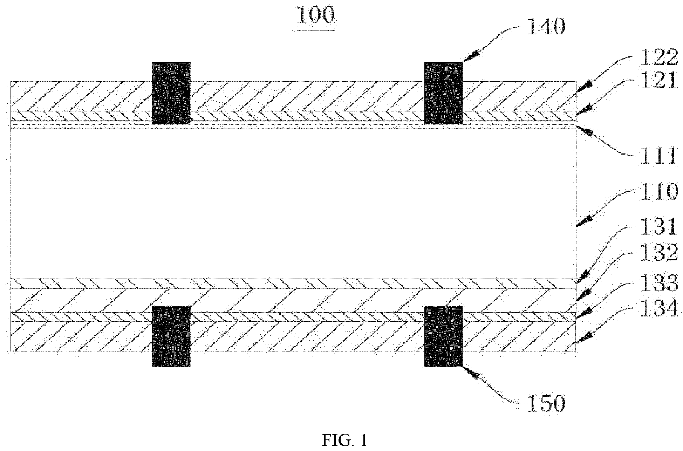

FIG. 1 is a schematic structural vie of a solar cell provided according to an embodiment of the present application.

Reference numerals: 100. TOPCon cell; 110. N-type silicon wafer; 111. boron-diffused layer; 121. front aluminum oxide film; 122. front silicon nitride film; 131. doped silicon oxide layer; 132. doped polycrystalline silicon film; 133. back aluminum oxide film; 134. back silicon nitride film; 140. front metal electrode; and 150. back metal electrode.

### DETAILED DESCRIPTION OF THE EMBODIMENTS

In order to facilitate an understanding of the present application, the present application will now be described more fully hereinafter with reference to the accompanying drawings. Preferred embodiments of the present application are shown in the drawings. The present application may, however, be embodied in many different forms and is not limited to the embodiments described herein. On the contrary, the purpose of providing these embodiments is to provide a more thorough and comprehensive understanding of the disclosed content of the present application.

Unless defined otherwise, all technical and scientific terms used herein have the same meaning as commonly understood by one of ordinary skill in the art to which the present application belongs. The terminology used herein in the description of the present application is for the purpose of describing particular embodiments only and is not intended to be limiting of the application. The term "and/or" used herein includes any and all combinations of one or more related listed items, and "many" used herein includes two or more items.

As compared to the passivated emitter and rear contact (PERC) cell which has been produced on a large scale currently, the TOPCon cell has a better photoelectric conversion efficiency and is highly compatibility with the production line of the PERC cell the whole of which can be upgraded and transformed only by adding a boron diffusion device, a polycrystalline silicon film deposition device, and a wrap-around removing and washing device. Hence, the TOPCon cell is a highly promising and efficient crystalline silicon solar cell technology, and has been gradually industrialized in China since in recent years.

In order to make objects, technical solutions, and advantages of the embodiments of the present application clearer, the following clearly and completely describes the technical solutions in the embodiments of the present application. Unless otherwise specifically stated, the conditions in the embodiments are conventional conditions or as suggested by the manufacturers. Unless otherwise noted with the manufacturer, the reagents or instruments used are conventional products that can be purchased commercially.

The solar cell and the preparation method thereof according to the embodiments of the present application will be described in detail below.

Referring to FIG. 1, an embodiment of the present application provides a solar cell, specifically, a TOPCon cell 100.

Referring to FIG. 1, the structure of the cell can include a crystalline silicon substrate. The crystalline silicon substrate can include an N-type silicon wafer 110. A doped silicon oxide layer 131, a doped polycrystalline silicon (poly-Si) film 132, and a back aluminum oxide (AlOₓ) film 133 are sequentially disposed on a back side of the crystalline silicon substrate. A back metal electrode 150 is further disposed on the back side of the crystalline silicon substrate. The back metal electrode 150 passes through the back aluminum oxide film 133 to form contact with the doped polycrystalline silicon film 132.

In the present application, on basis of a conventional structure of the TOPCon cell, an additional layer of AlOₓ film is disposed on the back side to solve the problem of burning-through of the polycrystalline silicon film by the metal paste.

In some examples of this embodiment, the doped polycrystalline silicon film 132 has a thickness of 5 nm to 50 nm. The problem of parasitic absorption of near infrared light can also be solved by using the ultra-thin polycrystalline silicon film of 5 nm to 50 nm.

Referring to FIG. 1, in some examples of this embodiment, the solar cell further includes a back silicon nitride (SiNₓ) film 134 disposed on a side of the back aluminum oxide film 133 away from the crystalline silicon substrate. The back silicon nitride film 134 can have an effect of passivation.

In some examples of this embodiment, the back silicon nitride film 134 has a thickness of 70 nm to 100 nm.

Referring to FIG. 1, in some examples of this embodiment, the solar cell further includes a front aluminum oxide film 121 disposed on a front side of the crystalline silicon substrate. The front aluminum oxide film 121 can be used as a passivation film.

In some examples of this embodiment, the front aluminum oxide film 121 has a thickness of 3 nm to 8 nm.

Referring to FIG. 1, in some examples of this embodiment, the solar cell further includes a front silicon nitride film 122 disposed on a side of the front aluminum oxide film 121 away from the crystalline silicon substrate. The front silicon nitride film can be used as a passivation and anti-reflection film.

In some examples of this embodiment, the front silicon nitride film 122 has a thickness of 70 nm to 100 nm.

Referring to FIG. 1, in some examples of this embodiment, the solar cell further includes a front metal electrode 140. The front metal electrode 140 passes through the front side silicon nitride film 122 and the front aluminum oxide film 121 to form contact with the crystalline silicon substrate.

Referring to FIG. 1, the crystalline silicon substrate includes a boron-diffused layer 111. The N-type silicon wafer 110 has a textured surface at the front side and a polished surface at the back side. The boron-diffused layer 111 is disposed on the textured surface. The front aluminum oxide film 121 is disposed on the boron-diffused layer 111. The front metal electrode 140 is in contact with the boron-diffused layer 111. The doped silicon oxide layer 131 is disposed on the polished surface.

In some examples of this embodiment, the doped silicon oxide layer 131 has a thickness of 1 nm to 2 nm.

In some examples of this embodiment, the back aluminum oxide film 133 has a thickness of 1 nm to 8 nm.

An embodiment of the present application further provides a method for preparing the solar cell, includes the following steps.
I. The front aluminum oxide film and the front silicon nitride film are sequentially formed on the front side of the crystalline silicon substrate. The doped silicon oxide layer 131, the doped polycrystalline silicon film 132, the back aluminum oxide film 133, and the back silicon nitride film 134 are sequentially formed on the back side of the crystalline silicon substrate. As an implementation, the specific process of this step is as follows.
   (1) texturing: an N-type silicon wafer 110 is textured by an 1% alkali solution, and then the silicon wafer is washed by hydrogen peroxide and an alkali.
   (2) boron diffusion: the silicon wafer obtained in step (1) is placed into a boron diffusion furnace, and an PN junction, i.e., a boron-diffused layer 111, is formed by diffusing BCl₃ into the surface of the silicon wafer at 900°C to 1050°C.
   (3) alkaline polishing: a borosilicate glass (BSG) wrapped around the back side of the silicon wafer in the boron diffusion in step (2) is removed by a chain hydrofluoric acid (HF) machine, and then the silicon wafer is transferred by a manipulator to a trough type alkaline polishing machine to remove the PN junction (i.e., the boron-diffused layer 111) formed on the back side and the lateral side of the silicon wafer by alkali etching;
   (4) SiO₂/poly-Si deposition: a doped silicon oxide layer 131 with a thickness of 1 nm to 2 nm and a doped amorphous silicon film with a thickness of 5 nm to 50 nm are sequentially formed on the back side of the silicon wafer from step (3) by a preparation method such as low-pressure chemical vapor deposition (LPCVD) or plasma-enhanced chemical vapor deposition (PECVD);
   (5) annealing: the silicon wafer from step (4) is annealed in a tubular annealing furnace at a temperature of 600°C to 1000°C for a time of 10 to 60 minutes, with nitrogen (N₂) or oxygen (O₂) as an annealing gas atmosphere, to transform the crystalline structure of the deposited amorphous silicon film to form a doped polycrystalline silicon film 132, i.e., a doped poly-Si film;
   (6) RCA cleaning: the silicon wafer from step (5) is firstly transferred to a chain HF machine to remove the oxide layer wrapped around the front side and produced in the annealing process, and then transferred to an alkali tank to remove the poly-Si wrapped around the front side.
   (7) deposition of AlOₓ on the front and back sides: a front aluminum oxide film 121 and a back aluminum oxide film 133 are respectively deposited on the front and back sides of the silicon wafer from step (6) by a preparation method such as atomic layer deposition (ALD), plasma enhanced chemical vapor deposition (PECVD) or plasma enhanced atomic layer deposition (PEALD), so that the front and back sides of the cell structure are each provided with a passivation layer of aluminum oxide.
      In some examples of this embodiment, the front aluminum oxide film 121 and the back aluminum oxide film 133 can be prepared in one step by the same preparation method, or in two separate steps by different preparation methods.
      In some examples of this embodiment, the front aluminum oxide film 121 has a thickness of 3 nm to 8 nm and the back aluminum oxide film 133 has a thickness of 1 nm to 8 nm.
   (8) deposition of silicon nitride on the front and the back sides: a front silicon nitride film 122 and a back silicon nitride film 134 are respectively formed on the front and the back sides of the silicon wafer from step (7) by a preparation method of PECVD; the front silicon nitride film 122 and the back silicon nitride film 134 can be prepared in one step or in two separate steps, with the thicknesses thereof each being 70 nm to 100 nm.
II. A metal paste is screen printed on each of the front silicon nitride film 122 and the back silicon nitride film 134 to successively prepare the back metal electrode 150 and the front metal electrode 140.
III. Light injection, efficiency testing, and sorting.

The features and performances of the present application will be further described in detail below with reference to examples.

### Example 1:

This example provides a TOPCon cell 100, with a doped SiO₂ layer and a doped polycrystalline film 132 on a back side thereof prepared by PECVD method, and AlOₓ films (i.e., a front AlOₓ film 121 and a back AlOₓ film 133) on two sides thereof prepared by ALD method. The specific method is as follows.
(1) texturing: an N-type silicon wafer 110 was textured by an 1% alkali solution, and then the silicon wafer was washed by hydrogen peroxide and an alkali.
(2) boron diffusion: the silicon wafer entered a boron diffusion furnace, and an PN junction was formed by diffusing BCl₃ at 1030 °C.
(3) alkaline polishing: a BSG wrapped around the back side in the boron diffusion was removed by a chain HF machine, and then the silicon wafer was transferred by a manipulator to a trough type alkaline polishing machine to remove the PN junction formed on the back side and the lateral side of the silicon wafer while remaining the PN junction (i.e., the boron-diffused layer 111) on the front side of the silicon wafer.
(4) SiO₂/poly-Si deposition: the PECVD method was used; nitrous oxide (N₂O) was introduced to perform a plasma reaction at 380 °C to form a doped silicon oxide layer 131 with a thickness of 1.5 nm on the back side; then the temperature was increased to 430 °C, and silane (SiH₄), phosphane (PH₃), and hydrogen gas (H₂) were introduced to perform a plasma reaction to further form a phosphorus-doped amorphous silicon film with a thickness of 40nm; and finally SiH₄ and N₂O were introduced to from a SiO₂ mask layer with a thickness of 20nm.
(5) annealing: an annealing process was performed in a tubular annealing furnace at a temperature of 900 °C for a time of 30 minutes, with nitrogen (N₂) as an annealing gas atmosphere, to transform the crystalline structure of the deposited amorphous silicon film to form a doped polycrystalline silicon film 132 with the thickness of 40nm.
(6) RCA cleaning: the silicon wafer was firstly transferred to a chain HF machine to remove the oxide layer wrapped around the front side and produced in the annealing process, and then transferred to an alkali tank to remove the poly-Si wrapped around the front side, and finally the oxide layer (including BSG, PSG, and the SiO₂ mask layer) on the front and back sides were removed by a trough HF machine.
(7) deposition of AlOₓ on the front and back sides: the ALD method was used, and trimethylaluminum (TMA) and water (H₂O) was introduced and a single wafer was inserted to perform a periodic circular reaction at 250 °C to simultaneously deposit a front AlOₓ film 121 and a back AlOₓ film 133; due to the difference in morphology between the front and back sides of the silicon wafer (the front side has a textured surface structure, and the back side has a polished surface structure), the front AlOₓ film 121 has a thickness of 3.5 nm, and the back AlOₓ film 133 has a thickness of 5 nm;
(8) a front SiNₓ film 122 and a back SiNₓ film 134 were respectively deposited by the PECVD method; the front SiNₓ film 122 has a thickness of 85 nm, and the back SiNₓ film 134 has a thickness of 95 nm.
(9) A metal paste was screen printed onto the front and back sides to successively prepare a back metal electrode 150 and a front metal electrode 140 and to enable the back metal electrode 150 to be in contact with the doped polycrystalline silicon film 132 and the front metal electrode 140 to be in contact with the boron-diffused layer 111.
(10) light injection, efficiency testing, and sorting.

### Example 2:

This example provides a TOPCon cell 100, which differs from Example 1 in that: the front AlOₓ film 121 and the back AlOₓ film 133 were deposited by different method in step (7), the front AlOₓ film 121 was deposited by the ALD manner, and the back AlOₓ film 133 was deposited by the PECVD method. The specific method was as follows: in an ALD furnace tube at 250 °C, two wafers opposite to each other were inserted, and trimethylaluminum (TMA) and water (H₂O) were introduced to perform a periodic circular reaction to form the front AlOₓ film 121 with a thickness of 3.5 nm on the front side by ALD; thereafter, the wafer was transferred into a PECVD furnace tube, a certain amount of TMA and N₂O were introduced to perform a plasma reaction at 200 °C to form the back AlOₓ film 133 with a thickness of 5 nm on the back side.

### Example 3:

This example provides a TOPCon cell 100, which differs from Example 1 in that: the front AlOₓ film 121 and the back AlOₓ film 133 were deposited by different method in step (7), the front AlOₓ film 121 was deposited by the ALD manner, and the back AlOₓ film 133 was deposited by the PEALD method. The specific method was as follows: in an ALD furnace tube at 250 °C, two cell wafers opposite to each other were inserted, and trimethylaluminum (TMA) and water (H₂O) were introduced to perform a periodic circular reaction to form the front AlOₓ film 121 with a thickness of 3.5 nm on the front side by ALD; thereafter, the wafer was transferred into a PEALD furnace tube, a certain amount of TMA and O₂ were introduced to perform a plasma-enhanced periodic circular reaction at 200 °C to form the back AlOₓ film 133 with a thickness of 5 nm.

### Example 4:

This example provides a TOPCon cell 100, which differs from example 3 in that: in step (7), the deposition thicknesses of the front AlOₓ film 121 and the back AlOₓ film 133 were different. The front AlOₓ film 121 was deposited by the ALD method and has a thickness of 3.5 nm. The back AlOₓ film 133 was deposited and prepared by the PEALD method, with the thickness increased to 7 nm to further enhance the protection effect on the back doped polycrystalline silicon film 132, and reduce the corrosion effect of the metal paste on poly-Si.

### Example 5:

This example provides a TOPCon cell 100, which differs from Example 1 in that: in step (4), the LPCVD method is used in the SiO₂/poly-Si deposition. At a temperature of 600 °C, a certain amount of O₂ was introduced into an LPCVD furnace tube to form the doped silicon oxide layer 131, and then SiH₄ and PH₃ was introduced to form the phosphorus-doped amorphous silicon film which is then annealed in N₂ form the doped polycrystalline silicon film 132 with a thickness of 40nm.

### Example 6:

This example provides a TOPCon cell 100, which differs from Example 1 in that the back AlOₓ film 133 has a thickness of 0.5 nm.

### Example 7:

This example provides a TOPCon cell 100, which differs from Example 1 in that the back AlOₓ film 133 has a thickness of 10 nm.

### Comparative Example 1

This comparative example provides a TOPCon cell, which differs from Example 1 in that: the doped polycrystalline silicon film has a thickness of 150 nm, and the process of forming the back AlOₓ film was canceled, i.e., the back AlOₓ film was not provided.

### Comparative Example 2

This comparative example provides a TOPCon cell, the doped polycrystalline silicon film of which has the same thickness as Example, both are 40 nm. The difference from Example 1 is in that in this comparative example, the process of forming the back AlOₓ film was canceled, i.e., the back AlOₓ film was not provided.

**Table 1 a list of electrical property parameters of the TOPCon cells in Examples and Comparative Examples**

| Group | Eta (%) | Voc (V) | Isc (A) | FF (%) | Rs (Ω) | Rsh (Ω) | IRev2 (A) |
|---|---|---|---|---|---|---|---|
| Example 1 | 24.51 | 0.7154 | 18.12 | 83.35 | 0.00072 | 1792 | 0.07 |
| Example 2 | 24.49 | 0.7150 | 18.11 | 83.39 | 0.00070 | 1892 | 0.09 |
| Example 3 | 24.47 | 0.7151 | 18.10 | 83.38 | 0.00071 | 1823 | 0.10 |
| Example 4 | 24.50 | 0.7156 | 18.12 | 83.32 | 0.00076 | 1733 | 0.09 |
| Example 5 | 24.47 | 0.7159 | 18.11 | 83.22 | 0.00082 | 1932 | 0.12 |
| Example 6 | 24.40 | 0.7130 | 18.10 | 83.37 | 0.00069 | 1648 | 0.06 |
| Example 7 | 24.39 | 0.7153 | 18.11 | 83.02 | 0.00088 | 1589 | 0.12 |
| Comparative example 1 | 24.45 | 0.7159 | 18.02 | 83.56 | 0.00064 | 1881 | 0.08 |
| Comparative example 2 | 24.39 | 0.7126 | 18.10 | 83.39 | 0.00061 | 1629 | 0.12 |
| Example 1 - Comparative example 1 | 0.06 | -0.0005 | 0.10 | -0.21 | 0.00008 | -89 | -0.01 |
| Example 1 - Comparative example 2 | 0.12 | 0.0028 | 0.02 | -0.04 | 0.00011 | 163 | -0.05 |

As shown in above Table 1, the TOPCon cell with the 40 nm doped poly-Si film and the double-side AlOₓ films prepared in Example 1 has an average photoelectric conversion efficiency of up to 24.51%, an open-circuit voltage Voc of up to 715.4 mV, a short-circuit current Isc of up to 18.12A, and a fill factor FF of up to 83.35%.

As compared to the TOPCon cell with the 150 nm doped poly-Si film and no back AlOₓ film prepared in Comparative Example 1, the TOPCon cell prepared in Example 1 has a reduced parasitic absorption at the back side, a short-circuit current Isc increased by 100 mA, an open-circuit voltage Voc slightly decreased by 0.5 mV, and a fill factor FF slightly decreased by 0.21%. The final solar cell in Example 1 has a photoelectric conversion efficiency increased by 0.06% as compared to Comparative Example 1.

In addition, as compared to the TOPCon cell with the 40 nm doped poly-Si film and no back AlOₓ film prepared in Comparative Example 2, the TOPCon cell prepared in Example 1 has an average efficiency increased by 0.12%, an Voc increased by 2.8mV, an Isc slightly increased by 20mA, and a FF slightly decreased by 0.04%, indicating that the presence of the back AlOₓ film can effectively reduce the corrosion damage of the metal paste to the ultra-thin poly-Si, has a significant protection effect on the passivation effect of the cell, and ensures that the Voc will not be significantly reduced.

In conclusion, in the solar cell of the embodiments of the present application based on the ultra-thin doped poly-Si film, the parasitic absorption of near-infrared light by the doped poly-Si is reduced, and the current loss of the solar cell is reduced. In addition, a dense aluminum oxide film is provided between the doped poly-Si film and the back silicon nitride film, reducing the damage of the metal paste on the back side to the doped poly-Si, and ensuring the passivation contact effect.

The foregoing descriptions are merely embodiments of the present application, but are not intended to limit the scope of protection of the present application. For those skilled in the art, the present application may have various modifications and variations. Any modifications, equivalent replacements, improvements and the like made within the spirit and principle of the present application shall belong to the scope of protection of the present application.

## Claims

1. A solar cell, comprising a crystalline silicon substrate, wherein a doped silicon oxide layer, a doped polycrystalline silicon film, and a back aluminum oxide film are sequentially disposed on a back side of the crystalline silicon substrate; a back metal electrode is disposed on the back side of the crystalline silicon substrate; and the back metal electrode passes through the back aluminum oxide film to form contact with the doped polycrystalline silicon film.

2. The solar cell according to claim 1, wherein the doped polycrystalline silicon film has a thickness of 5 nm to 50 nm.

3. The solar cell according to claim 1, wherein the solar cell further comprises a back silicon nitride film disposed on a side of the back aluminum oxide film away from the crystalline silicon substrate.

4. The solar cell according to claim 3, wherein the back silicon nitride film has a thickness of 70 nm to 100 nm.

5. The solar cell according to any one of claims 1 to 4, wherein the solar cell further comprises a front aluminum oxide film disposed on a front side of the crystalline silicon substrate.

6. The solar cell according to claim 5, wherein the front aluminum oxide film has a thickness of 3 nm to 8 nm.

7. The solar cell according to claim 5, wherein the solar cell further comprises a front silicon nitride film disposed on a side of the front aluminum oxide film away from the crystalline silicon substrate.

8. The solar cell according to claim 7, wherein the front silicon nitride film has a thickness of 70 nm to 100 nm.

9. The solar cell according to claim 7, wherein the solar cell further comprises a front metal electrode passing through the front silicon nitride film and the front aluminum oxide film to form contact with the crystalline silicon substrate.

10. The solar cell according to claim 9, wherein the crystalline silicon substrate comprises an N-type silicon wafer and a boron-diffused layer; the N-type silicon wafer has a textured surface on a front side thereof and a polished surface on a back side thereof; the boron-diffused layer is disposed on the textured surface; the front aluminum oxide film is disposed on the boron-diffused layer; the front metal electrode is in contact with the boron-diffused layer; and the doped silicon oxide layer is disposed on the polished surface.

11. The solar cell according to any one of claims 1 to 10, wherein the doped silicon oxide layer has a thickness of 1 nm to 2 nm.

12. The solar cell according to any one of claims 1 to 10, wherein the back aluminum oxide film has a thickness of 1 nm to 8 nm.

13. A preparation method of a solar cell, comprising steps of:
sequentially forming a doped silicon oxide layer, a doped polycrystalline silicon film, and a back aluminum oxide film on a back side of a crystalline silicon substrate; and
forming a back metal electrode on the back side of the crystalline silicon substrate, wherein the back metal electrode passes through the back aluminum oxide film to form contact with the doped polycrystalline silicon film.

14. The preparation method according to claim 13, wherein the doped polycrystalline silicon film has a thickness of 5 nm to 50 nm.

15. The preparation method according to claim 13, further comprising a step of forming a back silicon nitride film on the back aluminum oxide film.

16. The preparation method according to claim 15, wherein the back silicon nitride film has a thickness of 70 nm to 100 nm.

17. The preparation method according to claim 15, further comprising a step of forming a front silicon nitride film on a front side of the crystalline silicon substrate, wherein the front silicon nitride film and the back silicon nitride film are simultaneously deposited by the same preparation method which is a plasma-enhanced chemical vapor deposition.

18. The preparation method according to claim 17, wherein the front silicon nitride film has a thickness of 70 nm to 100 nm.

19. The preparation method according to any one of claims 13 to 18, further comprising a step of forming a front aluminum oxide film on a front side of the crystalline silicon substrate, wherein the front aluminum oxide film and the back aluminum oxide film are simultaneously deposited by the same preparation method or separately deposited by different preparation methods selecting from an atomic layer deposition, a plasma-enhanced chemical vapor deposition, or a plasma-enhanced atomic layer deposition.

20. The preparation method according to claim 19, wherein the front aluminum oxide film has a thickness of 3 nm to 8 nm.

21. The preparation method according to any one of claims 13 to 20, wherein the doped polycrystalline silicon film is prepared by low pressure chemical vapor deposition or plasma-enhanced chemical vapor deposition.

22. The preparation method according to any one of claims 13 to 20, wherein the crystalline silicon substrate is prepared by steps of:
texturing an N-type silicon wafer to form a textured surface on a front side of the N-type silicon wafer;
performing boron diffusion on surfaces of the textured N-type silicon wafer to form a boron-diffused layer; and
removing the boron-diffused layer formed on a back surface and a lateral surface of the N-type silicon wafer by alkali polishing to form a polished surface on the back side of the N-type silicon wafer.

23. The preparation method according to claim 22, wherein the boron-diffused layer is formed on the surfaces of the textured N-type silicon wafer by BCl₃ at 900°C to 1050°C.

24. The preparation method according to any one of claims 13 to 23, wherein the doped silicon oxide layer has a thickness of 1 nm to 2 nm.

25. The preparation method according to any one of claims 13 to 23, wherein the back aluminum oxide film has a thickness of 1 nm to 8 nm.
